# EUROPÄISCHE PATENTANMELDUNG

(11) **EP 1 753 034 A2**
(43) Veröffentlichungstag der Anmeldung: **14.02.2007**
(21) Anmeldenummer: 06010152.4
(22) Anmeldetag: 17.05.2006
(51) Int. Cl.: H01L 31/042

(54) **Modulsystem für Photovoltaikanlagen**

(30) Priorität: 19.05.2005 DE 202005007833 U
(71) Anmelder: Arnold, Karl-Heinz, 09405 Gornau (DE)
(72) Erfinder: Arnold, Karl-Heinz, 09405 Gornau (DE)
(74) Vertreter: Findeisen Hübner Neumann Seerig

(57) **Zusammenfassung**

Die Erfindung betrifft ein Modulsystem für Photovoltaikanlagen, bestehend aus mehreren bifacialen Modulen, die mit Abstand über dem Boden montiert sind und wobei unterhalb der Module ein Reflektor angeordnet ist, um das zwischen die Module scheinende Sonnenlicht an die Unterseite der Module zu reflektieren. Es wird die Aufgabe gelöst, ein solches Modulsystem zu schaffen, das auch in geographischen Lagen mit im Jahresmittel lediglich mittlerem bis niedrigem Sonnenstand eine effektive Umwandlung der verfügbaren Solarenergie ermöglicht. Dies wird erreicht, indem das System Module (M) mit etwa 30% Lichtdurchlässigkeit aufweist, von denen jeweils eine Vielzahl reihenförmig in Ost-West-Ausrichtung angeordnet ist und wobei jedem dieser Module (M) ein speziell berechneter Freiflächenreflektor (R) zugeordnet ist, der unterhalb der Module (M) und mit lediglich geringem Abstand über dem Boden abgestützt ist.

## Beschreibung

Die Erfindung betrifft ein Modulsystem für Photovoltaikanlagen, bestehend aus mehreren bifacialen Modulen, die mit Abstand über dem Boden montiert sind und wobei unterhalb der Module ein Reflektor angeordnet ist, um das zwischen die Module scheinende Sonnenlicht an die Unterseite der Module zu reflektieren.

Für die Bereitstellung von Energie werden bisher überwiegend thermische oder nukleare Prozesse genutzt, beispielsweise auf Grundlage fossiler Rohstoffe wie Heizöl und Kohle oder durch atomare Kernspaltung. Die hiermit verbundenen Nachteile und Risiken sind allgemein bekannt, wobei bezüglich der fossilen Rohstoffe neben begrenzter Verfügbarkeit insbesondere die globale Erwärmung durch Kohlendioxid und bezüglich der Nuklearenergie insbesondere die Gefährdung durch unkontrollierte Strahlung zu nennen sind. Deshalb wird zunehmend eine Nutzung alternativer Energiekonzepte angestrebt. In diesem Zusammenhang ist die Solarenergie von Interesse, für deren Nutzung bereits zahlreiche Lösungsansätze sowohl für Solarkollektoren als auch für photovoltaisch betriebene Einrichtungen vorgeschlagen worden sind.

Allerdings besteht ein grundsätzliches Problem von Photovoltaikanlagen darin, dass für eine effektive Energieumwandlung ein möglichst intensiver Lichteinfall auf das jeweilige Photovoltaikmodul notwendig ist. Dies wird beispielsweise realisiert, indem die Module in Abhängigkeit vom Sonnenstand verlagert werden, wobei solche Konstruktionen u.a. aus WO 95/00 806 A1, DE 43 41 552 A1 und DE 197 18 358 A1 bekannt sind.

Ferner wurde bereits vorgeschlagen, Sonnenlicht auf die Photovoltaikelemente als Bündel zu richten, um die nutzbare Energie zu erhöhen. Dies erfolgt entweder mittels optischer Linsen und Prismen gemäß DE 197 32 548 A1 und DE 10 2004 001 248 B3 oder mit Spiegeln gemäß DE 44 33 476 A1 und DE 100 26 014 A1.

Weitere technische Lösungen schlagen eine Kombination von "Bündelsystemen" mit einer sonnenstandsabhängig veränderbaren Ausrichtung der Module vor, beispielsweise gemäß DE 198 04 469 A1 oder DE 197 02 943 A1.

Die bisher benannten Fundstellen ermöglichen zwar oftmals eine relativ gute Ausnutzung der Solarenergie, sie erfordern jedoch einen erheblichen gerätetechnischen Aufwand für die Ausgestaltung der Baugruppen, mit denen die sonnenstandsabhängige Ausrichtung der Module erfolgt. Dies bewirkt, ungeachtet der ohnehin erheblichen Kosten für Photovoltaikmodule, einen großen zusätzlichen Kostenaufwand, der durch die notwendige Wartung und den Betrieb der beweglichen Komponenten weiter erhöht wird. Demzufolge haben diesbezügliche Anlagen bisher eine lediglich geringe Akzeptanz erreicht.

Deshalb werden große Photovoltaikanlagen vorzugsweise mit einer Vielzahl von Modulen ausgestattet, die in langen Reihen nebeneinander und hintereinander sowie ortsfest angeordnet sind. Damit sich auch bei niedrigem Sonnenstand keine oder nur geringe Verschattungen ergeben, müssen zwischen den Modulen allerdings ausreichende Abstände eingehalten werden, welche die Nutzbarkeit der vorhandenen Fläche abhängig von deren Neigung teilweise erheblich einschränken.

Zur Vermeidung derartiger Nachteile wird in US 5 538 563 A eine Vorrichtung mit einer fachwerkartigen Rahmenstruktur vorgeschlagen, an deren Oberseite mehrere Reihen mit bifacialen Photovoltaikelementen angeordnet sind. Zwischen zwei benachbarten Reihen ist jeweils ein Freiraum vorgesehen, in dem unterhalb der Module in einem Winkel von 45° eine Reflektorfläche angeordnet ist. Somit kann Sonnenlicht, das nicht auf die obere Modulfläche auftrifft, sondern in den daneben liegenden Freiraum scheint, zurück auf die untere Modulfläche reflektiert werden. Allerdings ist diese technische Lösung - obwohl vom grundlegenden Lösungsansatz an sich interessant - nur für geographische Lagen mit einem durchgehend hohen Sonnenstand geeignet, also vorwiegend für tropische und subtropische Klimazonen.

Aufgabe der Erfindung ist es, ein Modulsystem für Photovoltaikanlagen zu schaffen, das auch in geographischen Lagen mit im Jahresmittel lediglich mittlerem bis niedrigem Sonnenstand eine effektive Umwandlung der verfügbaren Solarenergie ermöglicht.

Diese Aufgabe wird gelöst, indem das System bifaciale Module mit etwa 30% Lichtdurchlässigkeit aufweist. Eine Vielzahl derartiger Module ist jeweils reihenförmig in Ost-West-Richtung und in einer Höhe von mehr als einem Meter über dem Boden angeordnet. Die jeweils optimale Höhe wird unter Beachtung der geographischen Breite und der Hanglage berechnet. Der Abstand zwischen zwei jeweils benachbarten Modulreihen ist derart ausgestaltet, dass auch zum Zeitpunkt des jahreszeitlich niedrigsten Sonnenstandes zur Mittagszeit (in Mitteleuropa am 21. Dezember) keine Verschattung einer Modulfläche durch eine andere Modulfläche bewirkt wird. Folglich scheint die Sonne bei höheren Sonnenständen und somit fast über das gesamte Jahr auch auf die Zwischenräume in den Modulreihen, von denen sie auf die ebenfalls photovoltaisch wirksame Unterseite der Module reflektiert wird.

Hierfür ist jedem dieser Module ein speziell berechneter Freiflächenreflektor zugeordnet. Der Freiflächenreflektor ist unterhalb der Module und mit lediglich geringem Abstand über dem Boden abgestützt. Er kann mehrere unterschiedlich ausgerichtete bzw. gekrümmte Segmente aufweisen, um eine optimale Ausrichtung auf unterschiedliche Sonnenstände zu gewährleisten. Ferner wird vorgeschlagen, dass der Freiflächenreflektor nicht fokussierend, sondern die Rückseite des jeweils zugeordneten Moduls gleichmäßig beleuchtend ausgestaltet ist, damit die einzelnen Solarzellen möglichst gleich viel Spannung und Strom liefern. Da die Sonnenhöhe nicht nur von der Jahreszeit abhängt, sondern auch von der Tageszeit, bewirken die Freiflächenreflektoren infolge der Ausrichtung der Modulreihen nicht nur während der höchsten Sonnenstände eines Tages eine Verbesserung des Energieertrages, sondern zu allen Zeitpunkten, in denen Sonnenlicht verfügbar ist.

Ferner ergeben sich für Herstellung, Montage, Positionierung und Wartung Vorteile, sofern jeweils Module und Freiflächenreflektoren an gemeinsamen Halterungen befestigt sind.

Die nicht mit Freiflächenreflektoren belegten Wege zwischen den Modulreihen können zusätzlich mit einem hellen Belagmaterial versehen werden, um auch das Streulicht aus diesen Bereichen zu reflektieren. Als kostengünstige Alternative ist es bei einem Verzicht auf Freiflächenreflektoren auch grundsätzlich möglich, dass der gesamten Fläche unterhalb der Module ein entsprechend reflektierendes Material zugeordnet wird.

Das vorgeschlagene Modulsystem für Photovoltaikanlagen lässt sich wirtschaftlich in geographischen Regionen zwischen etwa dem 45. Breitengrad bis fast zum Polarkreis verwenden. Allerdings sollten bei zunehmender Polarkreisnähe vorzugsweise Hanglagen genutzt werden, weil die niedrigen Stände der Wintersonne ansonsten zu große Abstände zwischen den Modulreihen erfordern.

Mit diesem Modulsystem kann die Ausnutzung der Solarenergie z.B. am 51. Breitengrad theoretisch um 85% gesteigert werden. Allerdings bewirkt u.a. die doppelte Beaufschlagung mit Sonnenlicht eine größere Erwärmung der Module als bei konventioneller Anordnung, so dass der tatsächlich erreichbare Ertrag niedriger liegen wird. Der genaue Wert hängt vom konkreten Standort ab. So wurden vom Anmelder bei Versuchen mit noch nicht optimal ausgestalteten Reflektordaten in Deutschland in der Region südlich von Chemnitz (50,45° nördliche Breite) 55% gemessen. Dies ist erheblich mehr als bei den bisher realisierten Anlagen mit einer sonnenstandsabhängig veränderbaren Ausrichtung der Module. Folglich sind mit der vorliegenden technischen Lösung wesentliche Vorteile bezüglich Energieumwandlung und Kosten gegenüber dem Stand der Technik erreichbar.

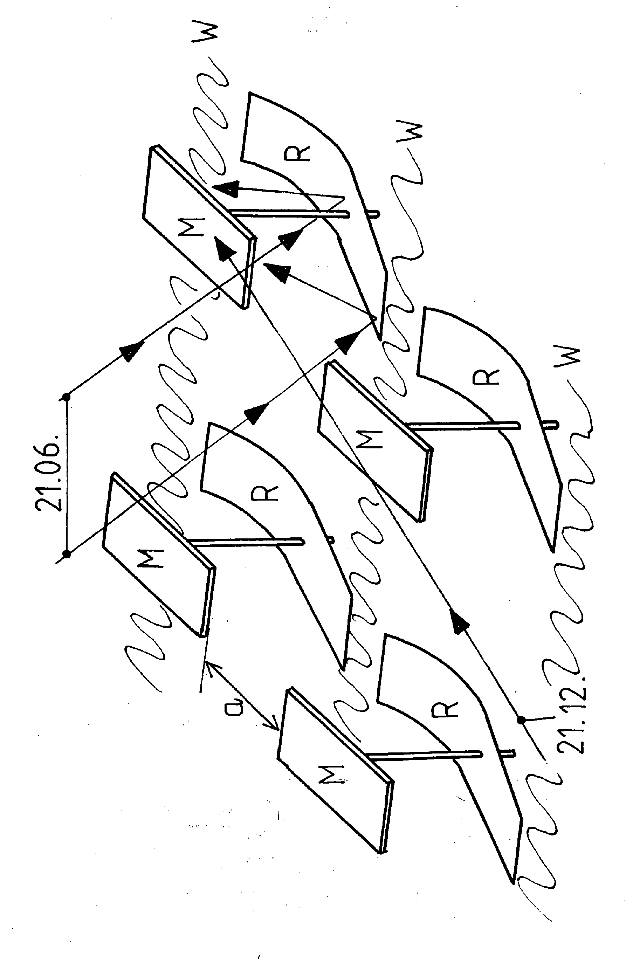

Ein Ausführungsbeispiel der Erfindung ist in der Zeichnung dargestellt, die einen Ausschnitt aus einer großflächigen Photovoltaikanlage zeigt. Die photovoltaischen Module sind mit "M" und die Freiflächenreflektoren sind mit "R" bezeichnet. Die verbleibenden freien Räume zwischen den Modulreihen "M - M" sind mit wellenförmigen Linien sowie dem Buchstaben "W" bezeichnet. Diese freien Räume "W", die auch als Wege für notwendige Wartungsarbeiten verfügbar sind, können mit einem gut reflektierenden Material belegt werden.

Die einfallenden Sonnenstrahlen sind in der Zeichnung mit Pfeillinien stilisiert, an denen jeweils das Datum des höchsten (21.06.) bzw. niedrigsten (21.12.) Sonnenstandes eines Jahres eingetragen ist. Außerdem ist aus dieser Darstellung der Strahlenverlauf zwischen zumindest einem Freiflächenreflektor "R" und einem Modul "M" sowie ein aus den eingezeichneten Strahlen einfach zu berechnender Abstand "a" zwischen benachbarten Modulreihen "M - M" ersichtlich.

## Patentansprüche

1. Modulsystem für Photovoltaikanlagen, bestehend aus mehreren bifacialen Modulen, die mit Abstand über dem Boden montiert sind und wobei unterhalb der Module ein Reflektor angeordnet ist, um das zwischen die Module scheinende Sonnenlicht an die Unterseite der Module zu reflektieren, **dadurch gekennzeichnet,**
**dass** das System Module (M) mit etwa 30% Lichtdurchlässigkeit aufweist, von denen jeweils eine Vielzahl reihenförmig in Ost-West-Ausrichtung angeordnet ist und wobei jedem dieser Module (M) ein speziell berechneter Freiflächenreflektor (R) zugeordnet ist, der unterhalb der Module (M) und mit lediglich geringem Abstand über dem Boden abgestützt ist.

2. Modulsystem nach Anspruch 1, **dadurch gekennzeichnet,**
**dass** die Module (M) in einer Höhe von mehr als einem Meter über dem Boden angeordnet sind, wobei die jeweils optimale Höhe unter Beachtung der geographischen Breite und der Hanglage berechnet wird.

3. Modulsystem nach Anspruch 1, **dadurch gekennzeichnet,**
**dass** der Abstand zwischen zwei jeweils benachbarten Modulen (M) derart ausgestaltet ist, dass auch zum Zeitpunkt des jahreszeitlich niedrigsten Mittags-Sonnenstandes (in Mitteleuropa am 21. Dezember) keine Verschattung einer Modulfläche durch eine andere Modulfläche bewirkt wird.

4. Modulsystem nach Anspruch 1, **dadurch gekennzeichnet,**
**dass** der Freiflächenreflektor (R) mehrere unterschiedlich gekrümmte Segmente aufweist.

5. Modulsystem nach Anspruch 1, **dadurch gekennzeichnet,**
**dass** der Freiflächenreflektor (R) in den Raum zwischen die Modulreihen (M - M) reicht.

6. Modulsystem nach Anspruch 1, **dadurch gekennzeichnet,**
**dass** der Freiflächenreflektor (R) die Rückseite des jeweils zugeordneten Moduls (M) gleichmäßig und nicht fokussierend beleuchtet.

7. Modulsystem nach Anspruch 1, **dadurch gekennzeichnet,**
**dass** Module (M) und Freiflächenreflektoren (R) an jeweils gemeinsamen Halterungen befestigt sind.

8. Modulsystem nach Anspruch 1, **dadurch gekennzeichnet,**
**dass** die Freiflächenreflektoren (R) aus eloxiertem Aluminium bestehen.

9. Modulsystem nach Anspruch 1, **dadurch gekennzeichnet,**
**dass** den verbleibenden freien Räumen (W) zwischen den Modulreihen (M - M) ein gut reflektierendes Material zugeordnet wird.

10. Modulsystem nach Anspruch 1, **dadurch gekennzeichnet,**
**dass** bei einem Verzicht auf Freiflächenreflektoren (R) der gesamten Fläche unterhalb der Module (M) ein gut reflektierendes Material zugeordnet wird.
